# EUROPEAN PATENT APPLICATION

(11) **EP 4 598 289 A1**
(43) Date of publication of application: **06.08.2025**
(21) Application number: 25155820.1
(22) Date of filing: 04.02.2025
(51) Int. Cl.: H05K 5/02, H05K 7/20

(54) **SLOT-MOUNTABLE RACK MOUNT MODULE CONFIGURED TO COOL ELECTRONICS RACK MOUNT**

(30) Priority: 05.02.2024 US 202418433154
(71) Applicant: Rockwell Collins, Inc., Cedar Rapids, IA 52498 (US)
(72) Inventor: LOVSETH, Jonathan A, Marion, 52302-9197 (US); MEHOLENSKY, Michael C., Marion, 52302-5904 (US)
(74) Representative: Dehns

(57) **Abstract**

A system includes a slot-mountable rack mount module (104). The slot-mountable rack mount module is shaped and sized to be mountable into a given rack mount slot of an electronics rack mount (102). The electronics rack mount has multiple rack mount slots including the given rack mount slot. The slot-mountable rack mount module includes: a vessel (202) containing at least one material (204). The at least one material is configured to absorb heat from within the electronics rack mount based at least on at least one of (a) at least one phase change of at least one of the at least one material or (b) at least one endothermic reaction of one or more of the at least one material.

## Description

### BACKGROUND

Currently, electronics modules need cooling to prevent them from overheating. Currently, many electronics rack mounts and/or electronics rack mount modules thereof use air cooling (e.g., which is typically loud and requires air intake and exhaust), liquid cooling (e.g., which typically requires external reservoirs and pumps), and/or heat pipes (e.g., which typically requires a specific condenser location, which can be expensive, and which can be inadequate for high power applications). Additionally, typically cooling uses specific cooling channels based on a platform's installation, which can require design time and custom interfaces for each platform.

### SUMMARY

According to the invention, there is provided a system. The system includes at least one slot-mountable rack mount module. Each of the at least one slot-mountable rack mount module is shaped and sized to be mountable into a given rack mount slot of an electronics rack mount. The electronics rack mount has multiple rack mount slots including each of said given rack mount slot. Each of the at least one slot-mountable rack mount module includes: at least one vessel containing at least one material. The at least one material is configured to absorb heat from within the electronics rack mount based at least on at least one of (a) at least one phase change of at least one of the at least one material or (b) at least one endothermic reaction of one or more of the at least one material.

### BRIEF DESCRIPTION OF THE DRAWINGS

Implementations of the inventive concepts disclosed herein may be better understood when consideration is given to the following detailed description thereof. Such description makes reference to the included drawings, which are not necessarily to scale, and in which some features may be exaggerated and some features may be omitted or may be represented schematically in the interest of clarity. Like reference numerals in the drawings may represent and refer to the same or similar element, feature, or function. In the drawings:
FIG. 1 is a view of an exemplary embodiment of a system according to the inventive concepts disclosed herein.
FIG. 2 is a view of an exemplary embodiment of a slot-mountable rack mount module of the system of FIG. 1 according to the inventive concepts disclosed herein.
FIGS. 3-4 are views of an exemplary embodiment of a slot-mountable rack mount module of the system of FIG. 1 according to the inventive concepts disclosed herein.
FIG. 5 is a view of an exemplary embodiment of a slot-mountable rack mount module of the system of FIG. 1 according to the inventive concepts disclosed herein.
FIGS. 6-7 are views of an exemplary embodiment of a slot-mountable rack mount module of the system of FIG. 1 according to the inventive concepts disclosed herein.
FIGS. 8, 9, 10, and 11 are views of exemplary embodiments of the system of FIG. 1 according to the inventive concepts disclosed herein.

### DETAILED DESCRIPTION

Before explaining at least one embodiment of the inventive concepts disclosed herein in detail, it is to be understood that the inventive concepts are not limited in their application to the details of construction and the arrangement of the components or steps or methodologies set forth in the following description or illustrated in the drawings. In the following detailed description of embodiments of the instant inventive concepts, numerous specific details are set forth in order to provide a more thorough understanding of the inventive concepts. However, it will be apparent to one of ordinary skill in the art having the benefit of the instant disclosure that the inventive concepts disclosed herein may be practiced without these specific details. In other instances, well-known features may not be described in detail to avoid unnecessarily complicating the instant disclosure. The inventive concepts disclosed herein are capable of other embodiments or of being practiced or carried out in various ways. Also, it is to be understood that the phraseology and terminology employed herein is for the purpose of description and should not be regarded as limiting.

As used herein a letter following a reference numeral is intended to reference an embodiment of the feature or element that may be similar, but not necessarily identical, to a previously described element or feature bearing the same reference numeral (e.g., 1, 1a, 1b). Such shorthand notations are used for purposes of convenience only, and should not be construed to limit the inventive concepts disclosed herein in any way unless expressly stated to the contrary.

Further, unless expressly stated to the contrary, "or" refers to an inclusive or and not to an exclusive or. For example, a condition A or B is satisfied by anyone of the following: A is true (or present) and B is false (or not present), A is false (or not present) and B is true (or present), and both A and B are true (or present).

In addition, use of the "a" or "an" are employed to describe elements and components of embodiments of the instant inventive concepts. This is done merely for convenience and to give a general sense of the inventive concepts, and "a" and "an" are intended to include one or at least one and the singular also includes the plural unless it is obvious that it is meant otherwise.

Finally, as used herein any reference to "one embodiment," or "some embodiments" means that a particular element, feature, structure, or characteristic described in connection with the embodiment is included in at least one embodiment of the inventive concepts disclosed herein. The appearances of the phrase "in some embodiments" in various places in the specification are not necessarily all referring to the same embodiment, and embodiments of the inventive concepts disclosed may include one or more of the features expressly described or inherently present herein, or any combination of sub-combination of two or more such features, along with any other features which may not necessarily be expressly described or inherently present in the instant invention.

Broadly, embodiments of the inventive concepts disclosed herein may be directed to a system including a slot-mountable rack mount module configured to cool an electronics rack mount. The slot-mountable rack mount module may include at least one material configured to absorb heat from within the electronics rack mount. For example, the at least one material may be configured to absorb heat from within the electronics rack mount based at least on (a) at least one phase change of at least one of the at least one material and/or (b) at least one endothermic reaction of one or more of the at least one material.

In some embodiments, the slot-mountable rack mount module may be a cooling system shaped and sized to fit into rack-mount slot (e.g., a standard rack-mount slot, such as a VPX, VNX, or PCI-express slot) of an electronics rack mount. In some embodiments, an electronics rack mount may include any suitable number of cooling slot-mountable rack mount modules and any suitable number of electronics rack mount modules. In some embodiments, the slot-mountable rack mount module may thermally interface with electronics rack mount modules and/or an electronics rack mount, such as via thermally conductive grease to adjacent electronics rack mount modules, wedge locks to adjacent electronics rack mount modules, and/or thermally conductive pins engaging a backplane of the electronics rack mount. In some embodiments, the slot-mountable rack mount module may be capable of providing cooling for 1.0 W*hr/in³, or more.

In some embodiments, the slot-mountable rack mount module(s) may provide a cooling solution that may simplify mission equipment scaling and/or that may extend mission duration or functionality of an electronics rack mount.

In some embodiments, phase changes can absorb eighty times more energy than merely heating a liquid.

In some embodiments, the slot-mountable rack mount module(s) may be useful for attritable and/or expendable platforms, such as missiles, air-launched effects (ALEs), or computing systems in small unmanned aerial vehicles (UAVs).

In some embodiments, each slot-mountable rack mount module may provide a predetermined cooling effect that can be easily and calculably increased within a rack mount through installation of at least one additional slot-mountable rack mount module. As one non-limiting example, each slot-mountable rack mount module can be 20Whr modules such that two slot-mountable rack mount modules could be installed to allow for cooling to accommodate 40W of additional power budget.

In some embodiments, a system operational duration may be extended during a mission through use of the slot-mountable rack mount module(s).

In some embodiments, slot-mountable rack mount module(s) (e.g., having cooling material(s) therein) may be installed in a slot(s) of a rack mount in a system. The slot-mountable rack mount module(s) can be programmed to communicate with a computing module of the rack mount (or with another onboard computing device), such as before or during a time of installation, before the system is operational, and/or before a mission begins. Once the system is operational electronics modules may generate heat, which the slot-mountable rack mount module(s) with cooling material may absorb. A processor of the system may obtain temperature information from a temperature sensor of the system and may cause an activator to activate at least one cooling material of the slot-mountable rack mount module(s); alternatively, the cooling material may passively begin cooling in response to the presence of heat. As such, the slot-mountable rack mount module(s) may begin absorbing heat. Further, a sensor(s) of the slot-mountable rack mount module(s) may report to the processor of the system how much more heat may be absorbed, a temperature and/or pressure of the vessel of the slot-mountable rack mount module, an estimated amount of cooling time remaining, a remaining amount (e.g., measured by weight or volume) cooling material remaining, or the like, such that the processor can determine how long the slot-mountable rack mount module(s) can extend the operational life of the system. In some embodiments, at some point, an amount of cooling capability of the material may be exhausted. Once exhausted, the slot-mountable rack mount module(s) can be refilled or discarded. If refilled, a refill indicator of the slot-mountable rack mount module(s) can be reset.

In some embodiments, each slot-mountable rack mount module can be used in non-vehicular and non-wearable platforms. For example, rack-mounted equipment can use a cooling slot-mountable rack mount module during a power outage, which may allow a system to go through a controlled-shutdown routine on backup power even if that backup power isn't enough to also continue to operate active cooling, e.g., such that the fans stop but computers can finish a shutdown-routine.

In some embodiments, each slot-mountable rack mount module can be easily installable, replaceable, refillable, or rechargeable at a depot or prior to a mission.

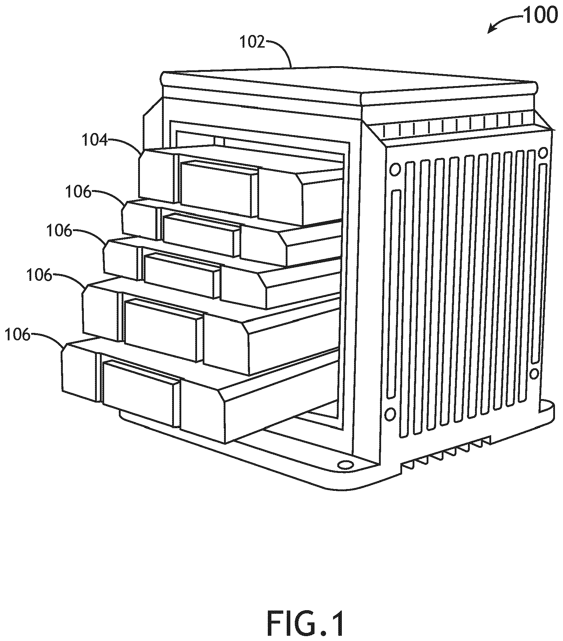

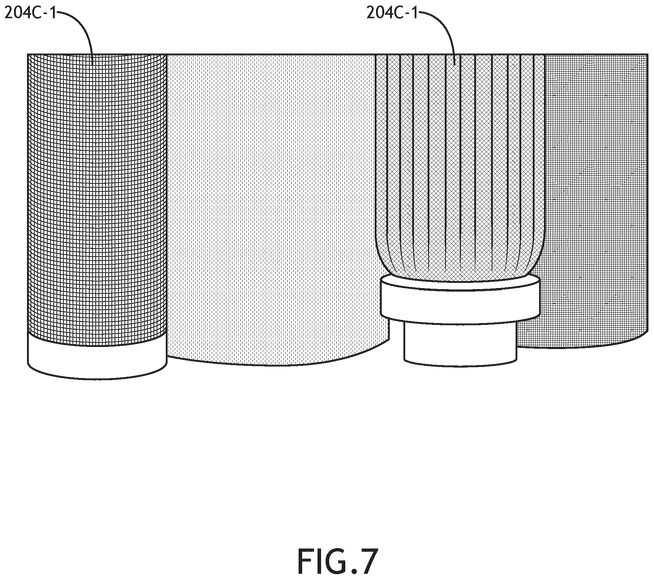

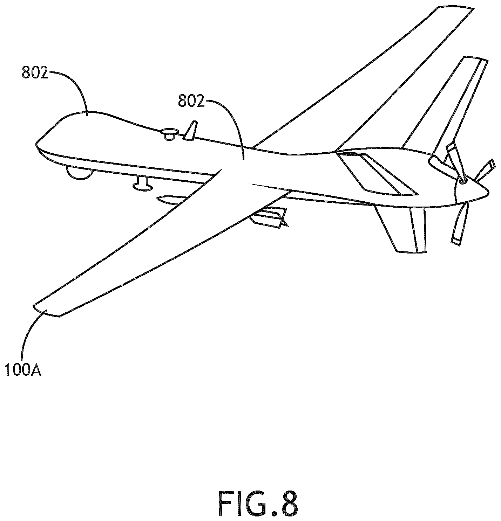

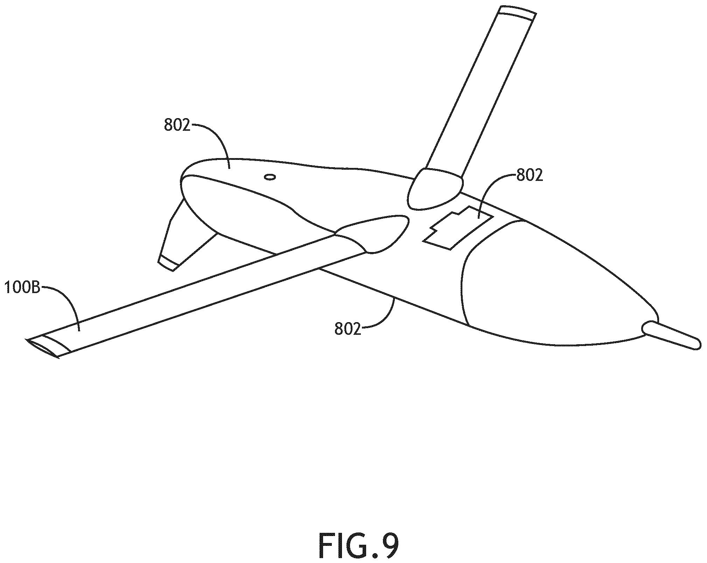

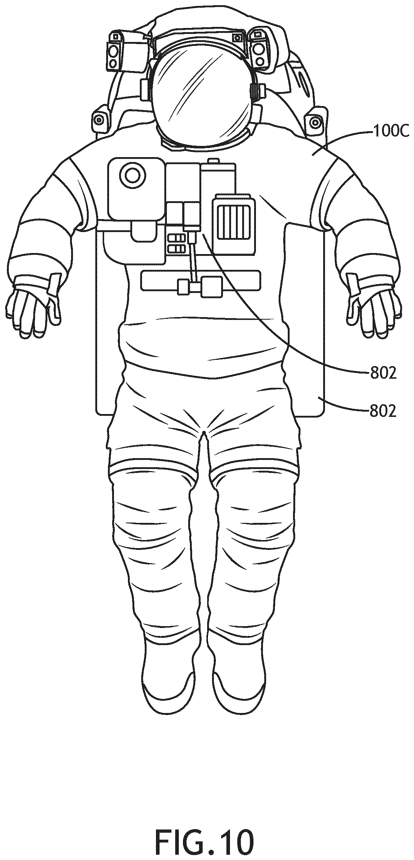

Referring generally to FIGS. 1-11, exemplary embodiments of a system 100 (e.g., a vehicle (e.g., an aircraft (e.g., an unmanned aerial vehicle (UAV) 100A (shown in FIG. 8) or an air-launched effect (ALE) 100B (shown in FIG. 9)), an automobile, a water craft (e.g., a ship or a submarine), a train, or a spacecraft), a munition (e.g., a missile), a wearable apparatus (e.g., a space suit 100C (shown in FIG. 10) or a manpack), a laptop computer, or a stationary computing site (e.g., a datacenter or a personal computer)), according to the inventive concepts disclosed herein are depicted.

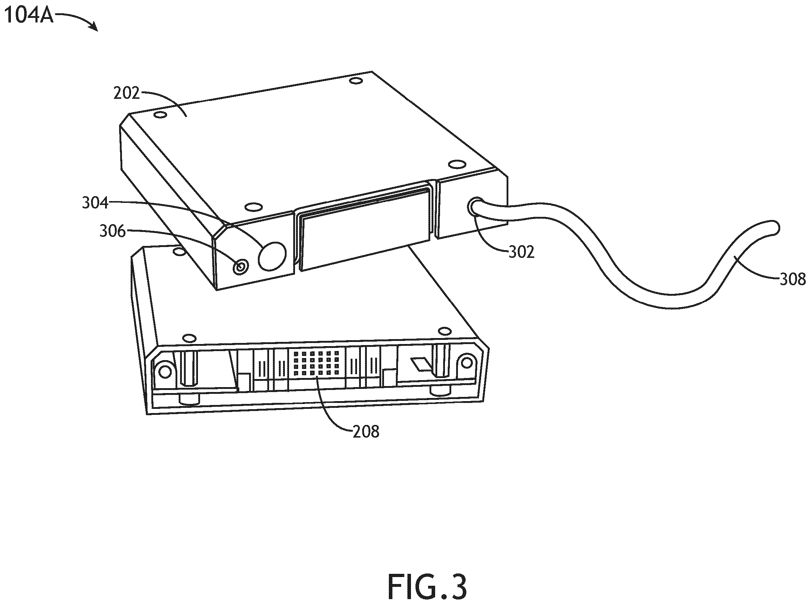

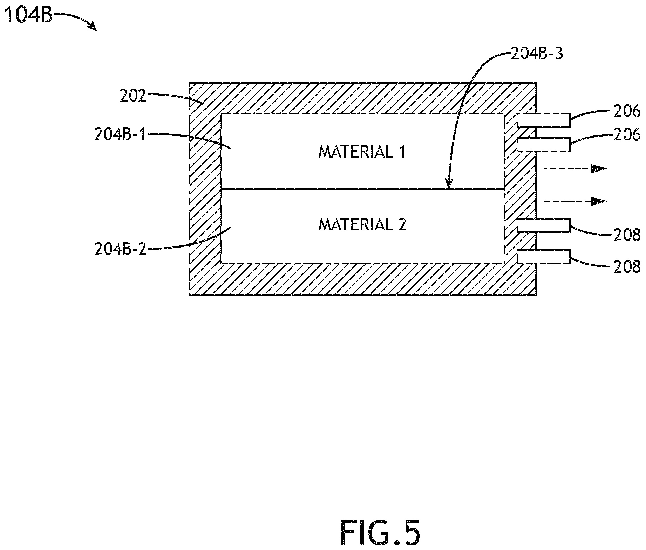

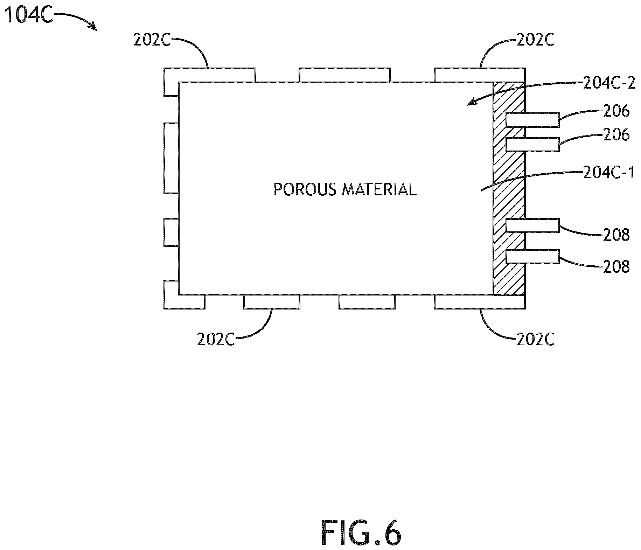

Referring now to FIGS. 1-2, exemplary embodiments of a system 100 including an electronics rack mount 102, according to the inventive concepts disclosed herein, are depicted. At least one slot-mountable rack mount module 104 (e.g., 104A shown in FIG. 3, 104B shown in FIG. 5, and/or 104C shown in FIG. 6) and at least one electronics rack mount module 106 may be shaped and sized to mount in slots of the electronics rack mount 102. For example, each slot-mountable rack mount module 104 and each electronics rack mount module 106 may be mounted into a given rack mount slot of the electronics rack mount 102.

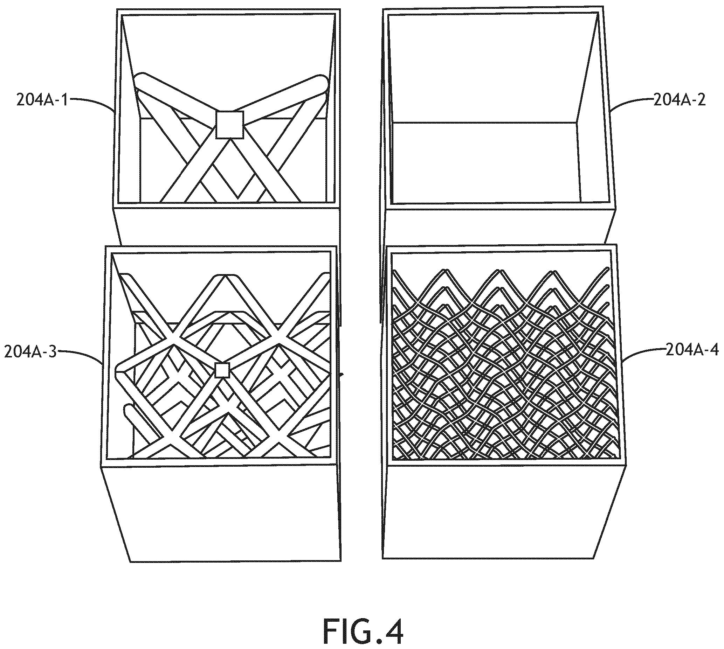

In some embodiments, each slot-mountable rack mount module 104 may include at least one vessel 202. Each vessel 202 may include at least one material 204 (e.g., 204A-1, 204A-2, 204A-3, and/or 204A-4 shown in FIG. 4; 204B-1, 204B-2, and/or 204B-3 shown in FIG. 5; and/or 204C-1 and/or 204C-2 shown in FIG. 6), which may be configured to absorb heat from within the electronics rack mount 102 based at least on (a) at least one phase change of at least one of the at least one material 204 and/or (b) at least one endothermic reaction of one or more of the at least one material 204. In some embodiments, the vessel 202 may be sealed or unsealed.

In some embodiments, there may be thermally conductive grease (not shown) between each slot-mountable rack mount module 104 and adjacent electronics rack mount module(s) 106. For example, each adjacent electronics rack mount module 106 may be adjacent to one or two of the at least one slot-mountable rack mount module 104.

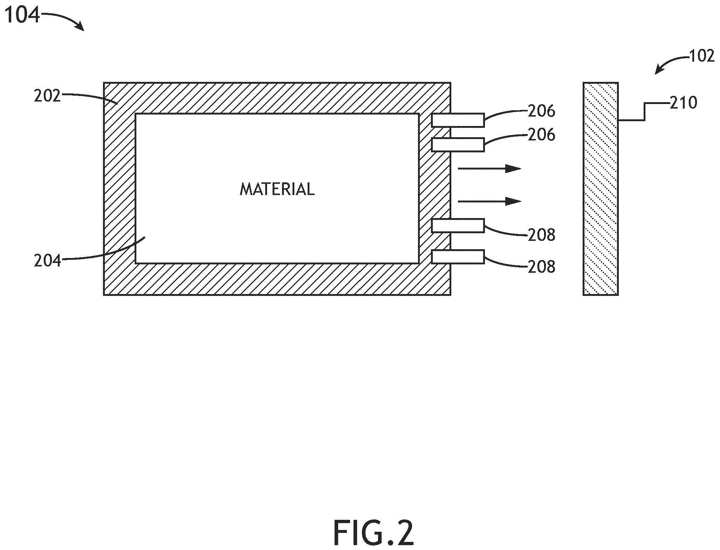

In some embodiments, each slot-mountable rack mount module 104 may include pins (e.g., data pins 206 and/or thermally conductive pins 208 (e.g., which may be configured to communicate data or may lack configuration to communicate data)) configured to connect to a backplane 210 of the electronics rack mount 102, such as shown in FIG. 2.

Referring now to FIGS. 3-4, an exemplary embodiment of a system 100 including an electronics rack mount 102 including at least one slot-mountable rack mount module 104A, according to the inventive concepts disclosed herein, is depicted. In some embodiments, the at least one material 204 (e.g., 204A-1, 204A-2, 204A-3, and/or 204A-4) is configured to absorb the heat from within the electronics rack mount 102 based at least on (a) the at least one phase change of the at least one of the at least one material 204. In some embodiments, the at least one phase change includes at least one of a solid-to-liquid phase change, a liquid-to-gas phase change, or a solid-to-gas phase change. For example, the slot-mountable rack mount module 104A may absorb heat from electronics rack mount module(s) 106 to cause the at least one phase change of the at least one of the at least one material 204. In some embodiments, the vessel 202 may be sealed; for example, the vessel 202 may be sealed at a pressure different (e.g., higher than or lower than) from 1 atmosphere to adjacent at least one phase change point (e.g., a melting point and/or a boiling point) of the at least one material 204A inside the vessel 202.

In some embodiments, the at least one material 204 may include at least one hydrocarbon (e.g., at least one wax (e.g., Paraffin wax, which may have a formula consistent with CₙH₂ₙ₊₂) and/or at least one oil), at least one non-Paraffin organics (e.g., at least one fatty acids polyethylene glycol (PEG), at least one polyalcohol, and/or polyethylene), at least one hydrated salt (e.g., hexahydrate (CaCl₂·6H₂O), tetrahydrate (CaCl2·4H2O), and/or Glauber's salt (also known as sodium sulfate decahydrate (Na₂SO₄·10H₂O))), at least one metallic glass (e.g., Chalchogenide (Ge-As-Te glass)), and/or dry ice. In some embodiments, the phase change points of the at least one material 204A may depend at least on a chemical mixture of the at least one material 204A. In some embodiments, the at least one material 204 may include at least one wax, wherein the at least one material 204 may be shaped in a pattern(s) (e.g., a lattice pattern(s)) at a time of installation in the electronics rack mount 102, such as shown in exemplary embodiments of FIG. 4. For example, wax formed in a lattice may undergo two phase changes when enough heat is applied to provide for additional heat absorption from two phase changes.

In some embodiments, each slot-mountable rack mount module 104 (e.g., 104A) may include at least one valve 302 and/or seal, at least one indicator 304, at least one fill port 306, and/or at least one tube 308.

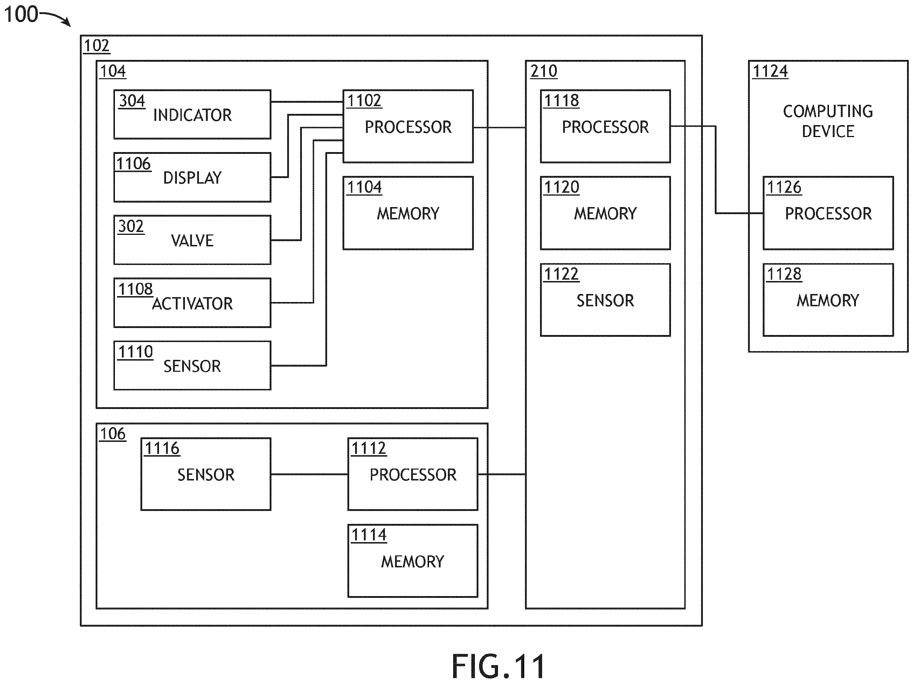

The valve 302 and/or seal may be configured to be (a) in a closed state at first pressure of the vessel 202 such that at least one material 204 is sealed within the vessel 202 at the first pressure and (b) in an at least partially open state at a second pressure such that at least some of the at least one material 204 exits the vessel 202. In some embodiments, when the valve 302 and/or seal is in the at least partially open state at the second pressure, the at least some of the at least one material 204 exits the vessel 202 through a tube 308 (e.g., a hose or piping (e.g., which may be rigid or flexible and which may be straight or include bends)) to a location (e.g., a collection reservoir or vented out of the system 100 (e.g., a vehicle)) outside of the electronics rack mount 102. For example, the valve 302 may be a pressure relief valve (e.g., set to open at a particular pressure) or a control valve (e.g., a solenoid valve; e.g., configured to be controlled by a processor (e.g., 1102, 1118, and/or 1126, shown in FIG. 11) in response to a sensed (e.g., by at least one sensor 1110, shown in FIG. 11) pressure and/or temperature within the vessel 202). For example, heat may cause the at least one material 204a to build up pressure inside the vessel 202 to a predetermined or controlled pressure when valve 302 opens to expel the gaseous and/or liquid phase of the at least one material 204A. In some embodiments, the tube 308 may direct where the expelled gaseous and/or liquid phase of the at least one material 204A travels.

In some embodiments, the at least one indicator 304 may indicate at least one of the following: an amount of the at least one material 204 in the vessel 202, a need to refill the at least one material 204 (such as immediately or soon (e.g., based on a predetermined weight of the at least one material 204 in the vessel 202)), a temperature of the vessel 202, a pressure of the vessel, an occurrence of at least one chemical reaction within the vessel 202, or a weight of the at least one material 204 within the vessel 202.

In some embodiments, the fill port 306 (e.g., for filling or refilling the vessel 202 with the at least one material 204 via automated machinery or manually) may be configured to receive the at least one material 204 and/or an additional amount of the at least one material 204.

Referring now to FIG. 5, an exemplary embodiment of a system 100 including an electronics rack mount 102 including at least one slot-mountable rack mount module 104B, according to the inventive concepts disclosed herein, is depicted. In some embodiments, the at least one material 204 is at least two materials (e.g., 204B-1 and/or 204B-2), wherein the at least two materials (e.g., 204B-1 and/or 204B-2) are configured to absorb heat from within the electronics rack mount based at least on (b) the at least one endothermic reaction of two or more (e.g., 204B-1 and/or 204B-2) of the at least two materials (e.g., 204B-1 and/or 204B-2). In some embodiments, the two or more (e.g., 204B-1 and/or 204B-2) of the at least two materials (e.g., 204B-1 and/or 204B-2) are separated (e.g., by at least one additional material (e.g., 204B-3) of the at least two materials (e.g., 204B-1, 204B-2, and/or 204B-3) such that the at least two materials may be at least three materials (e.g., 204B-1, 204B-2, and/or 204B-3)) at a time of installation in the electronics rack mount 102. In some embodiments, the two or more (e.g., 204B-1 and/or 204B-2) of the at least two materials (e.g., 204B-1 and/or 204B-2) may include (a) ammonium nitrate and/or calcium ammonium nitrate and (b) water. In some embodiments, the at least one additional material (e.g., 204B-3) of the at least two materials (e.g., 204B-1, 204B-2, and/or 204B-3) may be shaped as any suitable divisive structure, such as a meltable or sublimable wall or a meltable or sublimable encapsulant (e.g., spherical or pill shaped); for example, the at least one additional material (e.g., 204B-3) may include at least one wax, at least one hydrocarbon, at least one hydrated salt, and/or at least one metallic glass, which may change from solid to liquid as temperature exceeds a melting point thereof.

In some embodiments, the at least one endothermic reaction of the two or more (e.g., 204B-1 and/or 204B-2) of the at least two materials (e.g., 204B-1 and/or 204B-2) may be triggered by at least one of: manual control (e.g., at a start of a mission); at least one occurrence (e.g., as detected by at least one sensor (e.g., 1110 as shown in FIG. 11; e.g., an accelerometer) and activated by an activator 1108) of a threshold amount of acceleration or a higher order derivative thereof that causes (e.g., by physical jarring, such as from a rocket firing or turbulence) the at least one additional material 204B-3 to allow (e.g., by rupturing, tearing, and/or creating an opening in the at least one additional material 204B-3) the two or more 204B-1, 204B-2 of the at least three materials to mix; a temperature that melts the at least one additional material 204B-3; and/or at least one processor (e.g., 1102, 210, 1112, and/or 1126) controlling the activator 1108 to cause the two or more 204B-1, 204B-2 of the at least three materials to mix.

In some embodiments, resulting byproduct material(s) of the endothermic reaction of the two or more (e.g., 204B-1 and/or 204B-2) of the at least two materials may be undergo a liquid-to-gas phase change, which absorbs an additional amount of heat, and at least some of the gaseous and/or liquid phase(s) of the byproduct material(s) may be exhausted through a valve or a seal (e.g., similar to as shown in and described with respect to FIG. 3) to another location.

In some embodiments, the endothermic reaction may occur for a known or predictable duration of time. In some embodiments, the slot-mountable rack mount module 104C may be discarded and replaced in future missions.

In some embodiments, the vessel 202 may include the at least three materials (e.g., 204B-1, 204B-2, and 204B-3), which may be configured to absorb heat from within the electronics rack mount 102 based at least on (a) at least one phase change of the at least one additional material (e.g., 204B-3) of the at least three materials (e.g., 204B-1, 204B-2, and 204B-3) and (b) at least one endothermic reaction of the two or more (e.g., 204B-1 and 204B-2) of the at least three materials (e.g., 204B-1, 204B-2, and 204B-3).

In some embodiments, the at least one additional material (e.g., 204B-3) allows the two or more (e.g., 204B-1 and 204B-2) of the at least three materials (e.g., 204B-1, 204B-2, and 204B-3) to react based at least on at least one stimulus (e.g., an electrical stimulus, a thermal stimulus, a vibration stimulus, a force stimulus, and/or an acceleration stimulus) experienced by the at least one additional material (e.g., 204B-3).

Referring now to FIGS. 6-7, an exemplary embodiment of a system 100 including an electronics rack mount 102 including at least one slot-mountable rack mount module 104C, according to the inventive concepts disclosed herein, is depicted. In some embodiments, the at least one material 204 is at least two materials (e.g., 204C-1 and 204C-2). In some embodiments, the at least two materials (e.g., 204C-1 and 204C-2) include at least one porous material (e.g., 204C-1) and the at least one (e.g., 204C-2) of the at least two materials, wherein the at least two materials (e.g., 204C-1 and 204C-2) are configured to absorb the heat from within the electronics rack mount based at least on (a) the at least one phase change of the at least one (e.g., 204C-2) of the at least two materials. For example, the at least one phase change may be at least one liquid-to-gas phase change of the at least one (e.g., 204C-2) of the at least two materials. In some embodiments, the vessel 202 may be unsealed; for example, the vessel 202 may have openings (e.g., holes and/or pores), may be composed of the at least one porous material (e.g., 204C-1; e.g., which may be comprised of steel wool (e.g., 0000 grade) and/or pumice stone), and/or may partially surround the at least one porous material (e.g., 204C-1). In some embodiments, the at least one (e.g., 204C-2) of the at least two materials may include at least one of water, at least one salt, glycol, at least one hydrocarbon oil, or at least one alcohol.

In some embodiments, the at least one porous material (e.g., 204C-1) may be initially (e.g., at a time of installation of the module 104) saturated with a liquid phase of the at least one (e.g., 204C-2) of the at least two materials. For example, the liquid phase of the liquid (e.g., 204C-2) may stay within the at least one porous material (e.g., 204C-2), e.g., due to capillary action of small holes in the at least one porous material (e.g., 204C-1). For example, heat from adjacent electronics rack mount modules 106 may cause at least a portion of the liquid phase of the liquid (e.g., 204C-1) to undergo a phase change to a gas such that some or all of the liquid (e.g., 204C-1) boils out of the at least one porous material (e.g., 204C-2) while absorbing heat in the phase change process. Further, in some embodiments, the at least one porous material (e.g., 204C-1) may reabsorb the liquid phase of the liquid (e.g., 204C-1) if the temperature drops to cause the gas phase to condense. For example, such condensation may not occur on actively adjacent electronics because the electronics may be too hot for condensation to occur.

In some embodiments, the lot-mountable rack mount module 104C may be recharged by saturating the at least one porous material 204C-1 with the liquid phase of the liquid (e.g., 204C-2) and then replaced in the rack mount 102.

Referring now to FIG. 8, an exemplary embodiment of a UAV 100A including an electronics rack mount 102 including at least one slot-mountable rack mount module 104, according to the inventive concepts disclosed herein, is depicted. The UAV 100A may include at least one equipment access door 802 configured to provide access to the electronics rack mount 102.

Referring now to FIG. 9, an exemplary embodiment of an ALE 100B including an electronics rack mount 102 including at least one slot-mountable rack mount module 104, according to the inventive concepts disclosed herein, is depicted. The ALE 100B may include at least one equipment access door 802 configured to provide access to the electronics rack mount 102.

Referring now to FIG. 10, an exemplary embodiment of an ALE 100C including an electronics rack mount 102 including at least one slot-mountable rack mount module 104, according to the inventive concepts disclosed herein, is depicted. The space suit 100C may include at least one equipment access door 802 configured to provide access to the electronics rack mount 102.

Referring now to FIG. 11, an exemplary embodiment of the system 100 according to the inventive concepts disclosed herein is depicted. In some embodiments, the system 100 may include at least one electronics rack mount 102 and/or at least one onboard computing device 1124, some or all of which may be communicatively coupled at any given time.

The onboard computing device 1124 may include at least one processor 1126 and/or at least one memory 1128, some or all of which may be communicatively coupled at any given time.

The electronics rack mount 102 may include at least one backplane 210, at least one slot-mountable rack mount module 104, and/or at least one electronics rack mount module 106, some or all of which may be communicatively coupled at any given time.

The backplane 210 may include at least one processor 1118, at least one memory 1120, and/or at least one sensor 1122, some or all of which may be communicatively coupled at any given time.

The slot-mountable rack mount module 104 may include at least one processor 1102, at least one memory 1104, at least one indicator 302, at least one display 1106, at least one valve 302, at least one activator 1108, and/or at least one sensor 1110, some or all of which may be communicatively coupled at any given time.

The electronics rack mount module 106 may include at least one processor 1112, at least one memory 1114, and/or at least one sensor 1116, some or all of which may be communicatively coupled at any given time.

For example, the at least one processor 1126, the at least one processor 1118, the at least one processor 1102, and/or the at least one processor 1112 may include at least one at least one controller, at least one central processing unit (CPU), at least one graphics processing unit (GPU), at least one field-programmable gate array (FPGA), at least one application specific integrated circuit (ASIC), at least one digital signal processor, at least one virtual machine (VM) running on at least one processor, and/or the like configured to perform (e.g., collectively perform) any of the operations disclosed throughout. The processor 1126, 1118, 1102, and/or 1112 may be configured to run various software applications or computer code stored (e.g., maintained) in a non-transitory computer-readable medium (e.g., memory 1104, 1114, 1120, and/or 1128 and/or storage) and configured to execute various instructions or operations. The processor 1126, 1118, 1102, and/or 1112 may be configured to perform any or all of the operations disclosed throughout. For example, the at least one processor 1126, 1118, 1102, and/or 1112 may be configured to (e.g., collectively configured to, if more than one processor): communicate with another processor of the system 100 ; receive sensor information (e.g., as sensor data) of at least one sensed condition (e.g., a temperature, a pressure, a weight, a volume, a presence or absence of chemical(s) within the vessel, an acceleration (and/or at least one derivative thereof)) of the vessel 202 from the at least one sensor 1110; receive sensor information (e.g., as sensor data) of at least one sensed condition (e.g., a temperature, a presence or absence of chemical(s) within the rack mount 102, a flow, an acceleration (and/or at least one derivative thereof)) of the rack mount 102 from the at least one sensor 1110, 1116, and/or 1122; based at least on the sensor information from the sensors 1110, 1116, and/or 1122, estimate at least one of a remaining operational duration or an additional amount of heat that the slot-mountable rack mount module 104 can absorb; based at least on at least one of a preprogrammed system instruction or the sensor information from the sensors 1110, 1116, and/or 1122, trigger the activator 1108 to allow an endothermic reaction within the vessel 202; based at least on at least one of a preprogrammed system instruction or the sensor information from the sensors 1110, 1116, and/or 1122, control a valve (e.g., 302), such as to be in an open or closed state; based at least on at least one of a preprogrammed system instruction or the sensor information from the sensors 1110, 1116, and/or 1122, generate and/or output graphical data to the display 1106; based at least on at least one of a preprogrammed system instruction or the sensor information from the sensors 1110, 1116, and/or 1122, activate the indicator 304; and/or reset the indicator 304.

As will be appreciated from the above, embodiments of the inventive concepts disclosed herein may be directed to a system including a slot-mountable rack mount module configured to cool an electronics rack mount. The slot-mountable rack mount module may include at least one material configured to absorb heat from within the electronics rack mount. For example, the at least one material may be configured to absorb heat from within the electronics rack mount based at least on (a) at least one phase change of at least one of the at least one material and/or (b) at least one endothermic reaction of one or more of the at least one material.

As used throughout and as would be appreciated by those skilled in the art, "at least one non-transitory computer-readable medium" may refer to as at least one non-transitory computer-readable medium (e.g., at least one computer-readable medium implemented as hardware; e.g., at least one non-transitory processor-readable medium, at least one memory (e.g., at least one nonvolatile memory, at least one volatile memory, or a combination thereof; e.g., at least one random-access memory, at least one flash memory, at least one read-only memory (ROM) (e.g., at least one electrically erasable programmable read-only memory (EEPROM)), at least one on-processor memory (e.g., at least one on-processor cache, at least one on-processor buffer, at least one on-processor flash memory, at least one on-processor EEPROM, or a combination thereof), or a combination thereof), at least one storage device (e.g., at least one hard-disk drive, at least one tape drive, at least one solid-state drive, at least one flash drive, at least one readable and/or writable disk of at least one optical drive configured to read from and/or write to the at least one readable and/or writable disk, or a combination thereof), or a combination thereof).

As used throughout, "at least one" means one or a plurality of; for example, "at least one" may comprise one, two, three, ..., one hundred, or more. Similarly, as used throughout, "one or more" means one or a plurality of; for example, "one or more" may comprise one, two, three, ..., one hundred, or more. Further, as used throughout, "zero or more" means zero, one, or a plurality of; for example, "zero or more" may comprise zero, one, two, three, ..., one hundred, or more.

In the present invention, the methods, operations, and/or functionality disclosed may be implemented as sets of instructions or software readable by a device. Further, it is understood that the specific order or hierarchy of steps in the methods, operations, and/or functionality disclosed are examples of exemplary approaches. Based upon design preferences, it is understood that the specific order or hierarchy of steps in the methods, operations, and/or functionality can be rearranged while remaining within the scope of the inventive concepts disclosed herein. The accompanying claims may present elements of the various steps in a sample order, and are not necessarily meant to be limited to the specific order or hierarchy presented.

It is to be understood that embodiments of the methods according to the inventive concepts disclosed herein may include one or more of the steps described herein. Further, such steps may be carried out in any desired order and two or more of the steps may be carried out simultaneously with one another. Two or more of the steps disclosed herein may be combined in a single step, and in some embodiments, one or more of the steps may be carried out as two or more sub-steps. Further, other steps or sub-steps may be carried in addition to, or as substitutes to one or more of the steps disclosed herein.

From the above description, it is clear that the inventive concepts disclosed herein are well adapted to carry out the objects and to attain the advantages mentioned herein as well as those inherent in the inventive concepts disclosed herein. While presently preferred embodiments of the inventive concepts disclosed herein have been described for purposes of this disclosure, it will be understood that numerous changes may be made which will readily suggest themselves to those skilled in the art and which fall within the scope of the invention as defined by the claims.

## Claims

1. A system, comprising:
at least one slot-mountable rack mount module (106), each of the at least one slot-mountable rack mount module shaped and sized to be mountable into a given rack mount slot of an electronics rack mount (102), the electronics rack mount having multiple rack mount slots including each of said given rack mount slot, each of the at least one slot-mountable rack mount module comprising:
at least one vessel (202) containing at least one material (204), wherein the at least one material is configured to absorb heat from within the electronics rack mount based at least on at least one of (a) at least one phase change of at least one of the at least one material or (b) at least one endothermic reaction of one or more of the at least one material.

2. The system of claim 1, further comprising the electronics rack mount (202), wherein each of the at least one slot-mountable rack mount module is mounted into said given rack mount slot of the electronics rack mount.

3. The system of claim 2, wherein the electronics rack mount (202) includes at least one electronics rack mount module mounted within the electronics rack mount, wherein there is thermally conductive grease between each of the at least one slot-mountable rack mount module and at least one adjacent electronics rack mount module of the at least one electronics rack mount module, each of the at least one adjacent electronics rack mount module being adjacent to one or two of the at least one slot-mountable rack mount module.

4. The system of claim 2, further comprising a vehicle, the vehicle comprising the electronics rack mount, or further comprising a space suit, the space suit comprising the electronics rack mount.

5. The system of any preceding claim, wherein each of the at least one slot-mountable rack mount module includes thermally conductive pins (206) configured to connect to a backplane of the electronics rack mount.

6. The system of any preceding claim, wherein each of the at least one slot-mountable rack mount module further comprises at least one processor (1118) and at least one sensor (1116).

7. The system of any preceding claim, wherein the at least one material (204) is configured to absorb the heat from within the electronics rack mount based at least on (a) the at least one phase change of the at least one of the at least one material, and optionally wherein the at least one material comprises at least one of: at least one hydrocarbon, at least one non-Paraffin organic, at least one hydrated salt, at least one metallic glass, and/or dry ice, or wherein the at least one material comprises at least one wax, wherein the at least one material is shaped in a lattice pattern at a time of installation in the electronics rack mount.

8. The system of claim 7, wherein the at least one phase change comprises at least one of a solid-to-liquid phase change, a liquid-to-gas phase change, or a solid-to-gas phase change.

9. The system of claim 7 or 8, wherein each of the at least one slot-mountable rack mount module further comprises a valve (302) or a seal configured to be (a) in a closed state at first pressure of the vessel such that at least one material is sealed within the vessel at the first pressure and (b) in an at least partially open state at a second pressure such that at least some of the at least one material exits the vessel, and optionally wherein, when the valve or seal is in the at least partially open state at the second pressure, the at least some of the at least one material exits the vessel through a tube to a location outside of the electronics rack mount.

10. The system of claim 7, 8 or 9, wherein each of the at least one slot-mountable rack mount module further comprises a fill port (306) configured to receive the at least one material and/or an additional amount of the at least one material.

11. The system of claim 1, wherein the at least one material is at least two materials, wherein the at least two materials are configured to absorb heat from within the electronics rack mount based at least on (b) the at least one endothermic reaction of two or more of the at least two materials, and optionally wherein the two or more of the at least two materials are separated at a time of installation in the electronics rack mount, wherein the two or more of the at least two materials comprise (a) ammonium nitrate calcium and/or ammonium nitrate and (b) water.

12. The system of claim 11, wherein the at least two materials are at least three materials, wherein the at least three materials include at least one additional material, wherein the two or more of the at least three materials are separated by the at least one additional material at the time of installation in the electronics rack mount.

13. The system of claim 12, wherein the at least one additional material allows the two or more of the at least three materials to react based at least on at least one stimulus experienced by the at least one additional material.

14. The system of claim 1, wherein the at least one material is at least two materials, wherein the at least two materials include at least one porous material and the at least one of the at least two materials, wherein the at least two materials are configured to absorb the heat from within the electronics rack mount based at least on (a) the at least one phase change of the at least one of the at least two materials, wherein the at least one phase change comprises at least one liquid-to-gas phase change of the at least one of the at least two materials.

15. The system of claim 14, wherein the vessel is unsealed, wherein the at least one of the at least two materials comprises at least one of water, at least one salt, glycol, at least one hydrocarbon oil, or at least one alcohol.
